Europäisches Patentamt

European Patent Office

Office européen des brevets

(11) Publication number: **0 147 998**
**B1**

(12) EUROPEAN PATENT SPECIFICATION

(45) Date of publication of patent specification: **11.07.90**

(21) Application number: **84308891.5**

(22) Date of filing: **19.12.84**

(51) Int. Cl.⁵: **H 01 L 27/02**, H 01 L 27/08,
H 03 K 19/00

(54) Semiconductor IC output circuitry.

(30) Priority: **23.12.83 JP 243432/83**

(43) Date of publication of application:
**10.07.85 Bulletin 85/28**

(45) Publication of the grant of the patent:
**11.07.90 Bulletin 90/28**

(84) Designated Contracting States:
**DE FR GB**

(56) References cited:
**US-A-4 272 830**

**PATENTS ABSTRACTS OF JAPAN, vol. 7, no. 136 (E-181)1281r, 14th June 1983; & JP-A-58 51 536 (RICOH K.K.) 26-03-1983**

**PATENTS ABSTRACTS OF JAPAN, vol. 6, no. 251 (E-147)1129r, 10th December 1982; & JP-A-57 148 363 (TOKYO SHIBAURA DENKI K.K.) 13-09-1982**

(73) Proprietor: **FUJITSU LIMITED**
**1015, Kamikodanaka Nakahara-ku**
**Kawasaki-shi Kanagawa 211 (JP)**

(72) Inventor: **Fujii, Shigeru c/o Fujitsu Limited**
**Patent Department 1015 Kamikodanaka**
**Nakahara-ku Kawasaki-shi Kanagawa 211 (JP)**
Inventor: **Yamashita, Kouichi c/o Fujitsu**
**Limited**
**Patent Department 1015Kamikodanaka**
**Nakahara-ku Kawasaki-shi Kanagawa 211 (JP)**
Inventor: **Tanabe, Tomoaki c/o Fujitsu Limited**
**Patent Department 1015 Kamikodanaka**
**Nakahara-ku Kawasaki-shi Kanagawa 211 (JP)**
Inventor: **Kuniyasu, Yoshio c/o Fujitsu Limited**
**Patent Department 1015 Kamikodanaka**
**Nakahara-ku Kawasaki-shi Kanagawa 211 (JP)**

(74) Representative: **Sunderland, James Harry et al**
**HASELTINE LAKE & CO Hazlitt House 28**
**Southampton Buildings Chancery Lane**
**London WC2A 1AT (GB)**

**EP  0 147 998  B1**

(56) References cited:
**PROCEEDINGS OF THE 2ND INTERNATIONAL CONFERENCE ON SEMI-CUSTOM ICs, London, GB, 23rd-25th November 1982, pages 1-7, Prodex Ltd., Tunbridge Wells, Kent, GB: "Introduction of an ultra fast 8000-gate CMOS gate array"**

## Description

The present invention relates to a semiconductor integrated circuit, in particular a large or very large scale integrated circuit (LSI or VLSI) which includes gate array circuits comprising MIS (metal insulator semiconductor) or CMIS (complementary MIS) type FETs (field effect transistors), and more particularly concerns output circuitry of the semiconductor IC.

Generally, LSIs are provided with input buffer circuits (or level shifters), which equalize (level shift) input signal level to a level used in inner or internal logic circuitry of the LSI, and output buffer circuits which drive outer or external circuits or equipments. With increasing scale of integration of LSI's the number of gates included in an LSI may exceed a few tens of thousands of gates per chip, and the number of output gates may exceed two hundreds.

An output buffer circuit is required to have a high switching speed and a high driving capacity in order to drive various kinds of external load. There has however appeared a problem of noise, which is induced by switching of high level current of the output circuit. This is becoming a serious problem for LSI or VLSI (very large scale integration) circuits, the main logic circuitry of which is designed to operate with very small currents.

In order to clarify this point, and so that the advantage of the present invention will be apparent, a previous output buffer circuit, and the design concept thereof, will be described briefly.

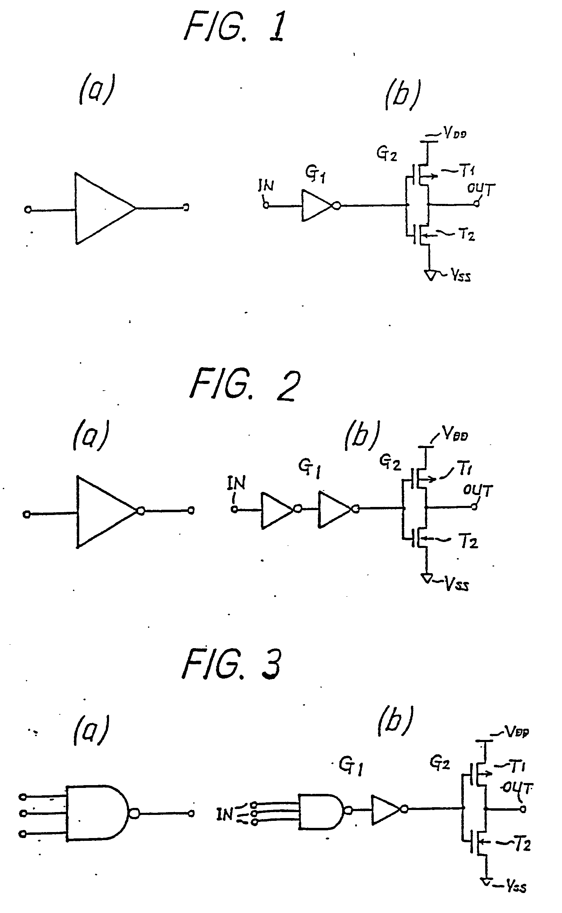

Circuit diagrams of some exemplary output gate circuits are shown in Figs. 1 to 3: Fig. 1 is a non-inverting output buffer circuit, Fig. 2 is an inverting output buffer circuit and Fig. 3 is a NAND type output buffer circuit exemplifying an output buffer circuit coupled with a NAND gate. In Figs. 1 to 3, (a) shows a symbol representing the circuit and (b) shows connections internal to the gate circuit. In the Figures, IN designates an input terminal which connects the gate circuit to the internal logic circuitry, OUT is an output terminal, and $G_1$ is a driver gate for an output buffer gate circuit $G_2$. $V_{DD}$ is a high voltage source and $V_{SS}$ is a low voltage source (usually earth potential). As can be seen in the Figures, the output buffer gate circuit $G_2$ consists of a complementary MOS (CMOS) circuit comprising p-channel MOS (p-MOS) FET $T_1$, and n-channel (n-MOS) FET $T_2$.

Driving force or driving capacity of the output buffer circuit is determined by output impedance or mutual conductance gm of the CMOS FETs $T_1$ and $T_2$. The following relation is known in the art for an FET

$$gm \; \alpha \; \beta \; \alpha \; \frac{W}{L}$$

where $\beta$ is current amplification factor of the transistor, W is gate width of the FET and L is gate length of the FET. Therefore, high driving capacity of the output buffer circuit can be attained by shortening the gate length L and making W large; that is, by elongating the transistor.

In a previous LSI the ratios W/L of transistors for an inner (internal) gate $G_0$, for a driving gate $G_1$ and for an output buffer gate $G_2$ are determined respectively as 1:3:10 or 1:5:20 for example, in the design state of the LSI. These ratios have been determined to minimize chip area, or to minimize switching time of output buffer gates.

Recently there have been some attempts to optimize the size of output buffer circuit and its driving stage. For example, Japanese Provisional Publication No. 57—148363 by K. Kinoshita (laid open on Sep. 9, 1982) or No. 58—127347 by S. Wakamatsu (laid open on Jul. 29, 1983) show such attempts. In these cases attempts are made to optimize the output circuit by introducing the idea of master slice technology, namely a plurality of transistors (FET) having predetermined sizes (for example three sizes in the ratio of 1:2:3) are fabricated at the I/O (input/output) circuit area of an IC chip, and they are connected properly by wiring patterns.

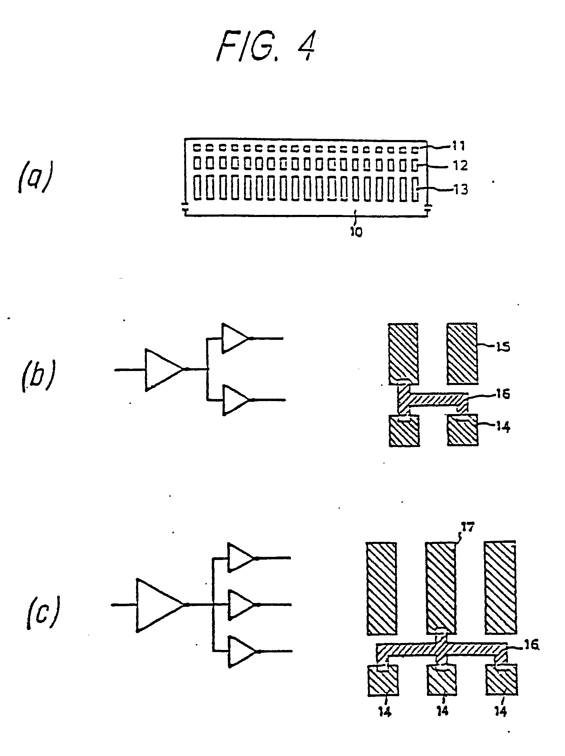

Fig. 4 illustrates these attempts in outline. In the Figure, (a) shows a part of the I/O area (IO) which is generally located at a peripheral part of the chip. As shown in the Figure, 11 are smallest size FETs, 12 are second size FETs (twice the size of FETs 11), and 13 are largest FETs (three times as large as FETs 11). If a two fan out circuit or a three fan out circuit is required, as shown in Fig. 4(b) or 4(c), appropriate size FETs are selected and connected to each other as shown in the Figure. For example, for a two fan out circuit a second size FET 15 is used to drive two small size FETs 14, and for a three fan out circuit the largest size FET 17 is used to drive three small FETs 14. In such a manner, a decrease in switching speed is prevented. In Fig. 4(b) and 4(c), 16 represents connections.

According to the present invention there is provided a semiconductor integrated circuit device, having a plurality of output circuits each comprising:

(i) an output buffer circuit having a relatively large current handling capacity and operable to provide an output signal to an external load, and

(ii) a driving buffer circuit having a relatively small current handling capacity and operable to provide signals to drive the output buffer circuit,

characterised in that the switching speed of the driving buffer circuit, for driving the output circuit buffer, is in the range over which the switching performance of the output circuit buffer is substantially determined by the switching speed of the driving buffer circuit, and in that the switching speed of the driving buffer

3

circuit is sufficiently low that switching noise, generated on a power supply line of the device upon switching of the output buffer circuit, is restricted, without reduction of the current handling capacity of the output buffer circuit.

As has been described above, previous output gate circuits are designed to operate as fast as possible. The high speed and high driving capacity of an output buffer circuit is attained by increasing the switching current handled by output transistors. However, switching of high currents causes an increased problem of induced noise, especially for very large scale integrated circuits (VLSI). The inner (internal) logic circuit, which is the main part of the logic circuit, is designed to work with a current as small as possible to avoid heat dissipation problems, but the switching current of the output circuit cannot be cut down because the output circuit has to drive an outer (external) circuit which generally has large stray capacity. Moreover, as the number of output buffer circuits increases, there occurs a chance that several output circuits will be working at the same instant, so that effectively a multiplied switching current induces noise in wiring lines or pins in the package of the IC, and causes malfunction of the main logic circuitry. This is becoming a serious problem for VLSI circuits.

Voltage fluctuation $V_N$ appearing on a $V_{ss}$ line is given as

$$V_N = RI + L \frac{dI}{dt}$$

where R is the wiring resistance, L is the inductance of the $V_{ss}$ line and I is the current flowing in the $V_{ss}$ line. This voltage fluctuation causes the noise and hence malfunction of the inner circuit (internal or main logic circuitry). So, if the circuit is designed to have a large value of W/L in order to achieve high switching speed or high driving capacity, current amplification factor $\beta$ also becomes large. Current I is proportional to $\beta$, which is proportional to W/L.

There exists a trade off, therefore, between achieving high speed switching or high driving capacity and decreasing switching noise. This is an especially serious consideration for LSI or VLSI circuits, wherein there are many output buffer circuits and thus an increased chance that more than one output buffer circuit may work at the same time, and when this happens the sum of the switching currents induces noise on the $V_{ss}$ line or on a $V_{DD}$ line which causes malfunction of the main logic circuitry.

An embodiment of the present invention can provide an output buffer circuit which has a high switching speed and high driving capacity but still has low switching noise.

An embodiment of the present invention provides a reduction in a noise induced by variation (switching) of high level current, for example, to stabilize (reduce) fluctuation of earth potential which is caused by switching of output buffer circuits in a semiconductor IC, e.g. a LSI or a VLSI.

The inventors have had the insight that the switching time of an output buffer circuit is mainly determined by the switching speed of its output gate so long as its driving gate circuit has sufficient switching speed and driving capacity. They have also appreciated that switching noise increases as I (current running through the circuit) and its time derivative dI/dt increase. Of these factors, I is determined by the external load which the IC must drive, so it cannot be decreased. However, the inventors have also had the insight that there is some room for decreasing the value of dI/dt. When dI/dt is decreased switching time is increased, but the inventors have appreciated that this is not serious, and that on the other hand switching noise is decreased drastically.

The output buffer circuit design concept provided by the inventors is exactly contrary to that of previous designs.

Control of the factor dI/dt is difficult to perform from the output side of the output gate, because the load varies often. In the present invention, control is effected from the input side of the gate circuit. According to an embodiment of the present invention, the switching speed of the driving circuit is controlled by applying master slice technology.

The present invention utilizes the fact that the transient current which runs through the output gate depends on the waveform of its input signal and does not depend on the load capacitance. According to a preferred embodiment of the invention, the gate size of the driving circuit (driver gate) FETs is intentionally decreased, accordingly the input waveform to the output buffer gate circuit is properly blunted, then the output waveform is similarly blunted, and transient currents in the output circuit are decreased. Thus the switching noise is decreased. Though the output waveform is slightly blunted, the maximum current supplied by the output buffer circuit does not vary, so the driving capacity of the circuit does not vary. In a further embodiment of the present invention, said control of the driver gate size is performed by master slice technology.

Reference is made, by way of example, to the accompanying drawings, in which:

Fig. 1 gives a symbol for and circuit diagram of a previously proposed exemplary non-inverting output buffer circuit,

Fig. 2 gives a symbol for and circuit diagram of a previously proposed exemplary inverting output buffer circuit,

Fig. 3 gives a symbol for and circuit diagram of a previously proposed NAND type buffer circuit,

Fig. 4 illustrates a construction and wiring connection of previously proposed output buffer circuitry utilizing master slice technology,

Fig. 5 is a circuit diagram of a previous non-inverting output buffer circuit,

Fig. 6 is a waveform diagram showing voltage, current and noise waveforms appearing at various points of the circuits of Fig. 5,

Fig. 7 is a graph showing characteristics of drain current vs drain voltage of a MIS FET,

Fig. 8 is a waveform diagram showing voltage, current and noise waveforms corresponding to Fig. 6, comparing improved waveforms provided by the present invention with waveforms of Fig. 6,

Fig. 9 is a circuit diagram of an output buffer circuit according to an embodiment of the present invention,

Fig. 10 shows plan view of a chip in accordance with an embodiment of the present invention, wherein:

(a) is a schematic plan view of the chip; and

(b) is an enlarged plan view showing a part of an I/O area of the chip,

Fig. 11 illustrates construction of output buffer circuit embodying the present invention,

(a) is a plan view of a CMIS FET pattern appearing on the chip before wiring;

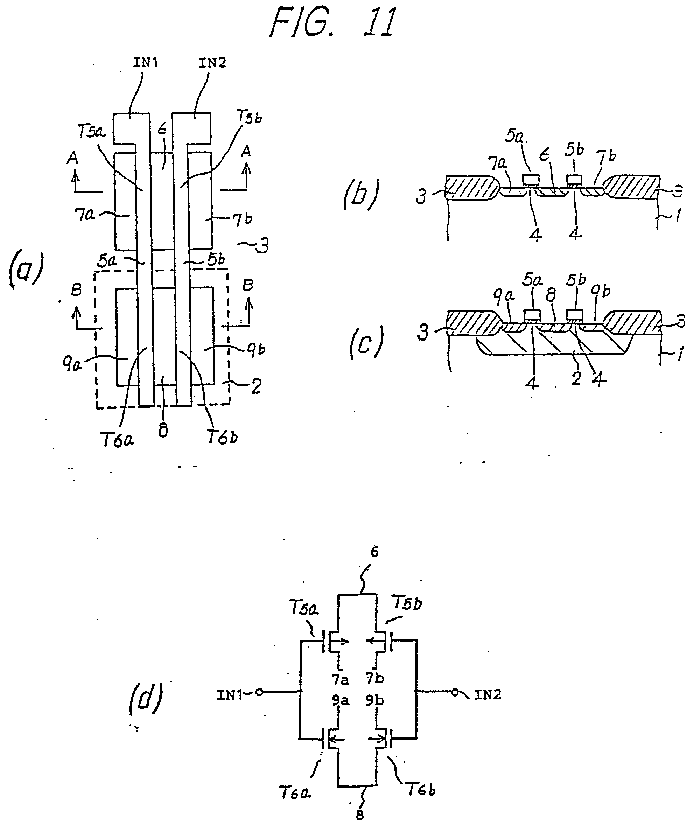

(b) shows a cross sectional view along a line AA in Fig. 11(a);

(c) shows a cross sectional view along a line BB in Fig. 11(a); and

(d) shows an equivalent circuit diagram,

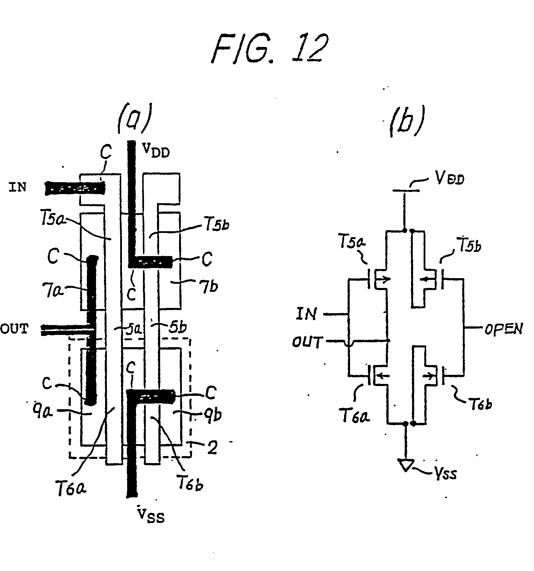

Fig. 12 shows an example of wiring of the pattern of Fig. 11(a), to decrease the driving capacity of the circuit to a half of a previous circuit, wherein:

(a) is a plan view illustrating the wiring pattern;

(b) is an equivalent circuit diagram,

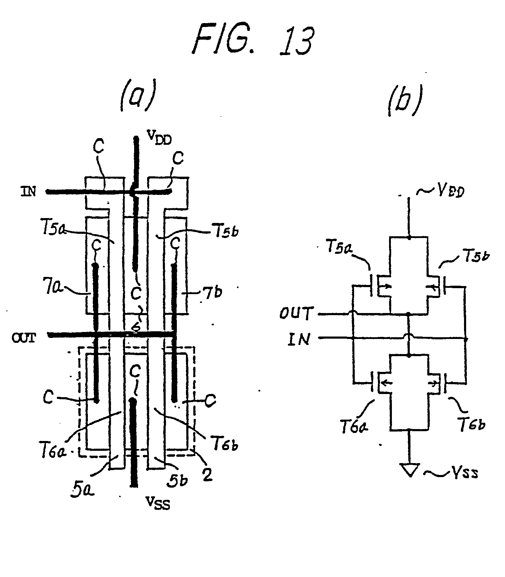

Fig. 13 shows another example of wiring of the pattern of Fig. 11(a), to provide the same driving capacity to that of a previous circuit, wherein:

(a) is a plan view illustrating the wiring pattern; and

(b) is an equivalent circuit diagram.

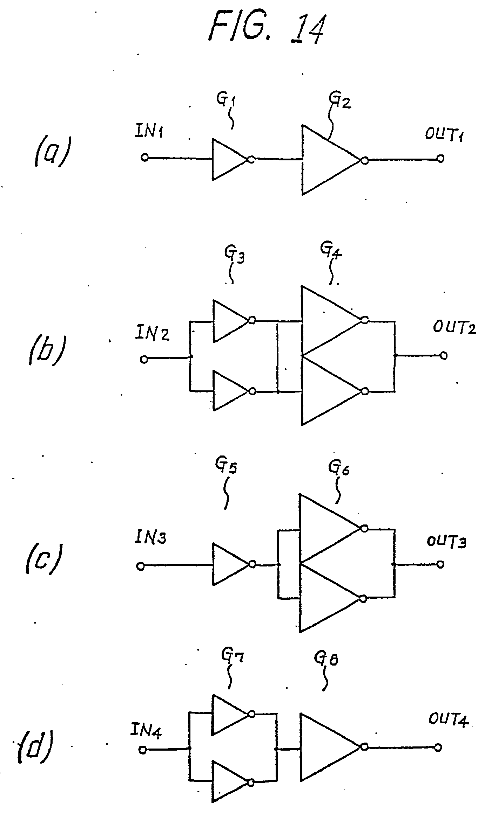

Fig. 14 gives symbols for typical output buffer circuits, illustrating how the driving capacity of the input and output buffer circuits are varied by combining unit circuits.

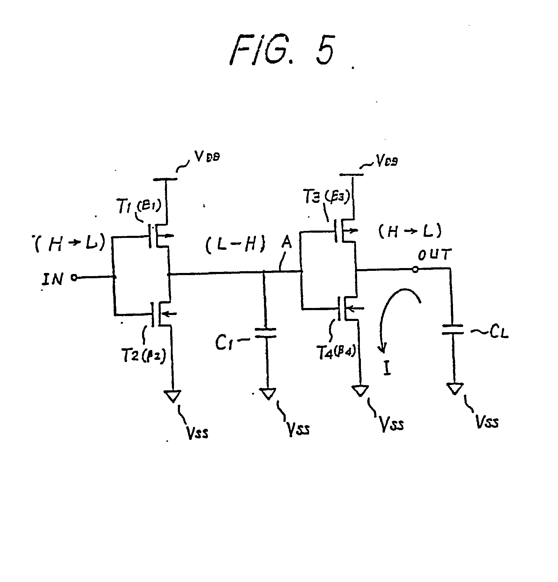

Fig. 5 shows a circuit diagram of an exemplary non-inverting output buffer circuit. The circuit uses two pairs of CMIS FETs: $T_1$, $T_2$ and $T_3$, $T_4$. $T_1$ and $T_3$ are p-channel FETs, and $T_2$ and $T_4$ are n-channel FETs. Each CMIS FET pair constitutes an inverter, and the inverters are operationally connected in series, so that together they work as a non-inverting type buffer circuit. In the Figure, IN designates an input terminal connected commonly to gate electrodes of FETs $T_1$ and $T_2$. Drain electrode of $T_1$ and source electrode of $T_2$ are connected to each other, and they are connected to gate electrodes of second stage inverter FETs $T_3$ and $T_4$. The drain electrode of $T_3$ and source electrode of $T_4$ are connected to each other and provide an output to an output terminal OUT. Source electrodes of $T_1$ and $T_3$ are connected to a positive voltage source $V_{DD}$, and drain electrodes of $T_2$ and $T_4$ are connected to a lower voltage source $V_{SS}$ (usually it is ground). $C_1$ represents stray capacitance of circuit wiring and gate electrodes of $T_3$ and $T_4$. $C_L$ represents stray capacitance of the load, including circuit wiring.

When the input signal is varied from high level (H) to low level (L), potential at a node point A in Fig. 5 varies from L to H. Then the n-channel FET $T_4$ becomes conductive (ON), and p-channel FET $T_3$ becomes non-conductive (OFF). So, charge stored in the load capacitance $C_L$ is discharged through the FET $T_4$, and the output signal varies from H to L.

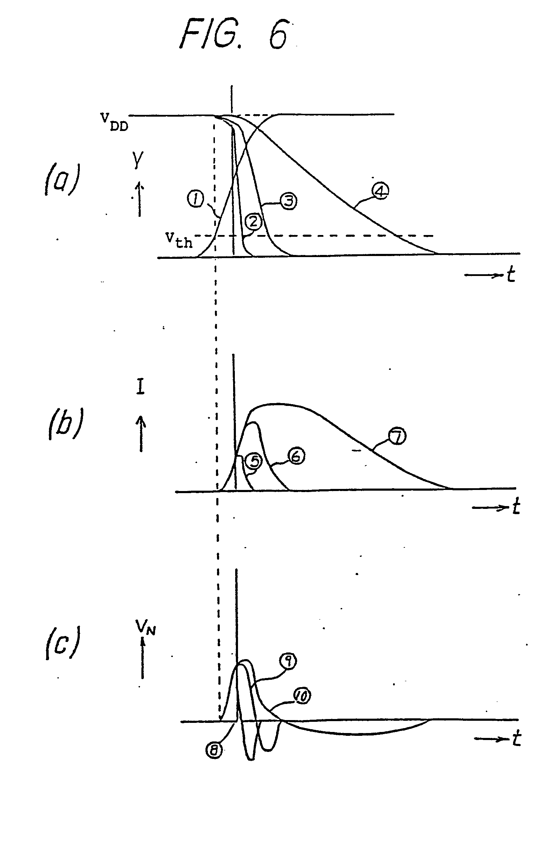

Fig. 6 shows waveforms which appear with such input signal variation at various points in the circuit of Fig. 5. In the Figure, curves (a), (b) and (c) show, respectively, voltage waveforms (V) at output terminal OUT, current waveforms of transient currents (I) running through the FET $T(_4)$, and noise voltages ($V_N$) induced in the $V_{SS}$ voltage source line.

In Fig. 6, (a), curve 1 represents the waveform of an input signal applied at the node point A (that is, it represents $V_{GS}$ of output FET $T_4$) illustrating the build up of that signal. Curve 2 represents the output voltage waveform when the load capacitance $C_L$ is very small. Curve 4 represents the output voltage waveform when the load capacitance is very large, and curve 3 represents the output voltage waveform when the load capacitance is intermediate between the cases of curves 2 and 4. As can be seen, the output voltage begins to drop as soon as the input voltage (curve 1) exceeds a lower threshold voltage $V_{thr}$, and the FET $T_4$ starts to pass current. In the case of curve 2, the output voltage goes down very rapidly and charge stored in the output capacitance is almost discharged before the input voltage rises up sufficiently for the current to increase to saturation current level, because the load capacitance $C_L$ is very small. However, in the case of the curve 4, the output voltage goes down slowly, so the input voltage goes up to the source voltage $V_{DD}$ (5 volts for example), and the FET $T_4$ becomes sufficiently ON so that saturation current flows in the FET $T_4$. Curve 3 corresponds to a case intermediate the two cases above.

Fig. 6(b) shows waveforms of currents running through the FET $T_4$. Curves 5, 6 and 7 in Fig. 6(b) correspond respectively to the cases of curves 2, 3 and 4 in Fig. 6(a). The current begins to flow as soon as the input voltage (curve 1) exceeds the threshold voltage $V_{th}$. When the load capacitance is small (curve 5), its charge is discharged soon with a small maximum current. When the load capacitance is very large (curve 7), the current goes up to the saturation current, and then goes down slowly. Curve 6 is an intermediate case.

Fig. 6(c) illustrates voltages induced by the currents running through the FET $T_4$ (which currents are shown in Fig. 6(b)). These voltages correspond to switching noise $V_N$. Curves 8, 9 and 10 in Fig. 6(c) correspond respectively to the cases of curves 2, 3 and 4 in Fig. 6(a).

Induced voltages are proportional to the time derivatives of currents (dI/dt), that is, the transient currents running through the output FET. If it is intended to decrease switching noise, it is necessary to reduce the peak values of the curves 8, 9 and 10 in Fig. 6(c).

It should be pointed out that noise voltage appears as both positive and negative voltages and, as can be seen in Fig. 6(c), the peak values of noise voltage do not differ much between the different curves 8, 9 and 10; namely, the noise does not depend on load capacitance. This means that the build-up of the current in the FET $T_4$ is determined by the voltage build-up (curve 1) in the input side (node A) of $T_4$.

To suppress the noise, it is necessary to blunt the waveform of the current in FET $T_4$.

Generally, the ground line ($V_{SS}$ line) of an LSI is made from aluminum or gold, and has resistance R and inductance L. More precisely, R and L can be divided into $R_1$, $R_2$ and $L_1$, $L_2$ respectively. Here, the suffix 1 designates that the value applies to the line in the LSI chip and suffix 2 designates that the value applies to the line from the chip to a pin of the chip package (usually, $R_1 < R_2$ and $L_1 < L_2$). Therefore, if a high current runs through the $V_{SS}$ line, the ground potential of the LSI chip varies, and causes malfunction of logic circuits. The variation of the ground level, or the noise $V_N$, can be expressed as

$$V_N \propto RI + L\frac{dI}{dt} \tag{1}$$

where $L = L_1 + L_2$ and $R = R_1 + R_2$.

In these equations, R is less than 0.1 $\Omega$, and it can be further decreased by making the $V_{SS}$ line thicker or increasing the number of $V_{SS}$ pins on the chip package and using them in parallel, so the effect of R can be eliminated. Therefore, the noise appearing in the $V_{SS}$ line mainly depends on the variation of current dI/dt in the $V_{SS}$ line.

This noise is induced on other pins of the LSI package and causes malfunctions of inner or internal logic circuits and external load equipments or circuits. Especially for VLSI circuits, since the number of output buffer circuits is increased, there occurs a chance of many output buffer circuits operating at the same instant, and thus of many switching currents rushing into the $V_{SS}$ line at the same time, and thereby increasing the noise.

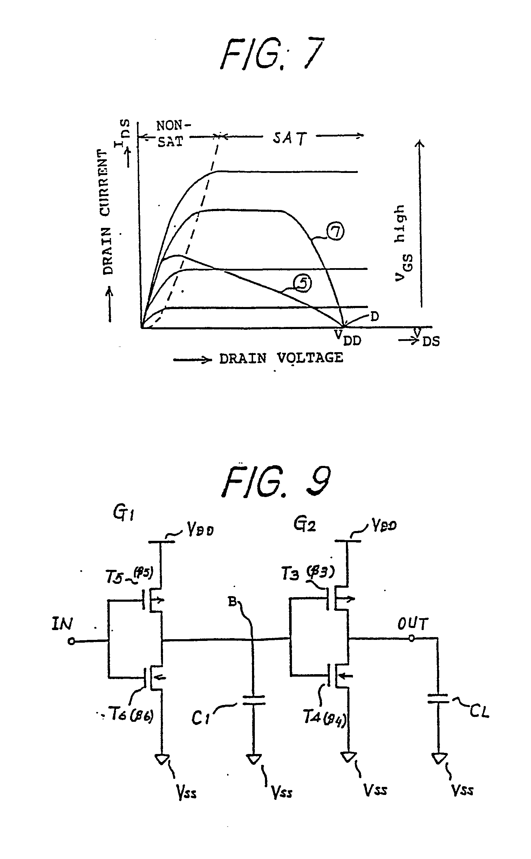

Fig. 7 shows relationships between drain current $I_{DS}$ and drain voltage $V_{DS}$ of an FET, for various gate voltages $V_{GS}$. As is known widely, the drain current $I_{DS}$ has a saturation region SAT and a non-saturation region NON-SAT.

The saturation current varies depending on the gate voltage $V_{GS}$. In the Figure, curves 5 and 7 are superposed which indicate the trajectory of drain voltage of output FET $T_4$, corresponding to curves 5 and 7 in Fig. 6(b).

Concerning curve 5, switching action starts from the point D where the current $I_{DS}$ is 0, and the voltage is $V_{DD}$. As the gate voltage $V_{GS}$ (input voltage) goes up, the current $I_{DS}$ begins to flow. At the same time the voltage $V_{SS}$ (output voltage) goes down, since the load capacitance is discharged through $T_4$. Since the load capacitance is small, the voltage drops rapidly, and the current $I_{DS}$ is small.

Concerning curve 7 of Fig. 7, the switching action starts from the point D similarly to the case of curve 5, but since the load capacitance is very large, the drain voltage goes down slowly, and as the gate voltage $V_{GS}$ goes up, the current $I_{DS}$ increases. After passing a maximum current which is determined by $V_{CC}$ and $V_{GS}$, (this is a saturation current, since $V_{GS} > V_{th}$) the current goes down. It should be pointed out that the inclinations of the curves 5 and 7 in Fig. 7 do not indicate steepness of current build-up, because the horizontal axis of Fig. 7 does not indicate time but rather drain voltage $V_{DS}$.

As can be seen in Fig. 7, when the FET is operating in the saturation region, the transient current running through the output FET depends on the load capacitance and the gate voltage. However, when the FET is operating in the non-saturation region, the transient current does not depend on the load capacitance. It is known that when the FET is operating in the saturation region, the current I running through the FET is given as

$$I \alpha \beta \cdot (V_{GS} - V_{th})^2. \tag{2}$$

The derivative of the current dI/dt is obtained by differentiating the equation (2) by t,

$$\frac{dI}{dt} \propto \beta \cdot (V_{GS} - V_{th}) \cdot \frac{dV_{GS}}{dt} \propto \sqrt{\beta} \cdot \sqrt{I} \cdot \frac{dV_{GS}}{dt} \tag{3}$$

where $\beta$ is current amplification factor, $V_{GS}$ is gate voltage and $V_{th}$ is threshold voltage.

As mentioned above, switching noise depends on the inductance L and on transient current dI/dt running through the output FET.

It is difficult to control transient current from the output side of the FET, since the current varies with the load capacitance. However, taking into account the fact that the transient current depends on the input signal level $V_{GS}$ of the output FET, the present invention intends to decrease the noise due to the switching current by providing for relatively slow variation of the input signal to the output FET. As mentioned before, this is a perfectly opposite design concept for an LSI circuit as compared with the prior art. By doing this, switching speed is slightly affected, but this is not serious, whereas noise is reduced drastically.

This can be explained as follows. The curves 5 and 7 in Fig. 7 can be considered to correspond respectively to a large $\beta$ FET and a small $\beta$ FET, having the same load capacitance. So, switching speed is determined by the $\beta$ or load capacitance of the final stage FET. In such a manner, the switching speed of a circuit is mainly determined by the switching speed of the final stage FET.

Generally, the final stage output FET is made as large as possible and its $\beta$ as high as possible, but usually the switching speed of the output buffer circuit is lower than that of its input driving buffer circuit, even though the $\beta$ or current flow is large. In other words the switching speed of the output buffer circuit is slower than that of the driving buffer circuit. In the present invention, the final stage FET is not altered as compared with previous proposals, so the driving capacity and switching speed of the output FET is not altered, but its input waveform is blunted, so the current build-up in the output FET is blunted, keeping its maximum current unaltered.

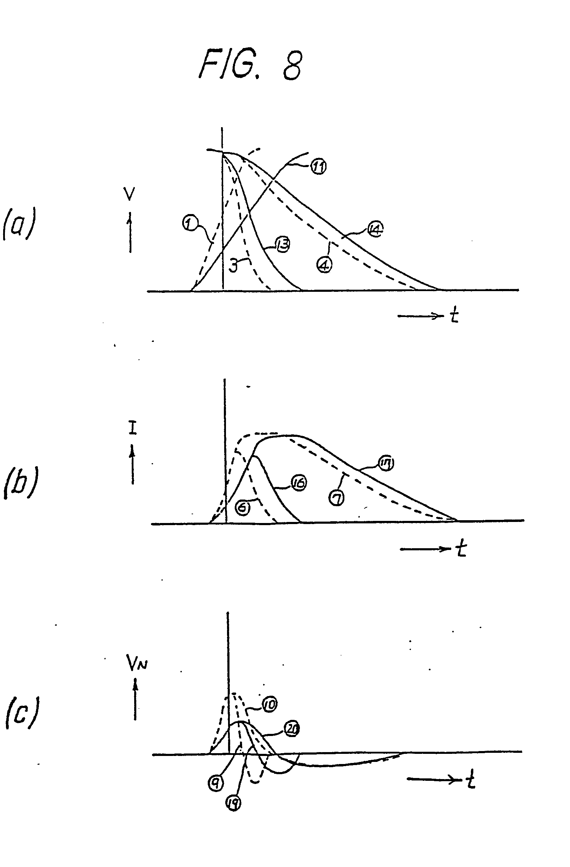

Fig. 8 shows curves corresponding to those of Fig. 6 but with input waveform blunting as mentioned above. Fig. 8(a) shows input and output voltage waveforms of the output FET, Fig. 8(b) shows current waveforms of current running through the output FET, and Fig. 8(c) shows noise voltage $V_N$ which appears in the $V_{SS}$ line when the output FET is switched ON and OFF. The Figure shows waveforms for the case when the intput signal is blunted (solid lines) and, for comparison, waveforms for the case when the input signal is not blunted (broken lines). Broken line waveforms in Fig. 8 correspond to waveforms in Fig. 6.

When the input signal is blunted slightly, for example the slope of the input signal represented by curve 11 is blunted to half that of the input signal represented by curve 1, curve 3 (which corresponds to output with a medium load capacitance) will be blunted to the curve 13. By this blunting the output current of curve 6 will be blunted to the curve 16, of which the build-up has half the steepness, because the build-up takes place with the FET in a saturation condition and the current is determined by the gate voltage (input voltage) of the FET. Thus, noise voltage decreases from that represented by curve 9 to that represented by curve 19, whose peak value is reduced by half.

With similar input signal blunting, if load capacitance is very large the waveform which is indicated by curve 4 will change to that of curve 14. In this case the change is not so marked, because the FET is saturated for both curves and the current is determined mostly by the load capacitance and the saturation current of the FET. Current variation in the FET changes from that represented by curve 7 to that represented by curve 17. Noise voltage decreases from that of curve 10 to that of curve 20.

Since the build-up of current is the same for different load capacitances (e.g. for medium load capacitance or large load capacitance — see curves 16 and 17), noise voltage corresponding to the current build-up is much the same in each case (see curves 19 and 20) but noise corresponding to build-down current is much lower for the large load capacitance than for the medium load capacitance.

In any event, noise voltage is decreased by half of that of the initial (Fig. 6) levels.

It will be noted from the Figures that switching time does not increase to twice its initial (Fig. 6) value. Particularly when load capacitance is large, the loss of switching speed (i.e. increase in switching time) is small.

In a general case, the switching action of the output buffer circuit corresponds to curve 4, and the switching action of the driving buffer circuit or its input signal corresponds to curve 3 or 2 in Fig. 6. Therefore in an embodiment of the present invention it is provided that the input signal to the output buffer circuit is blunted, and noise is reduced without undue loss of switching speed.

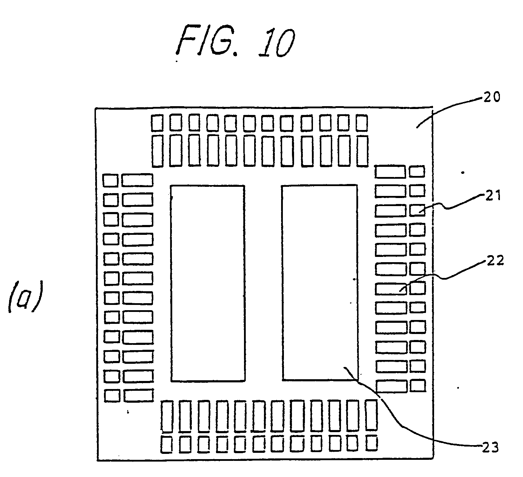

Fig. 9 shows a circuit diagram of an output buffer circuit in accordance with an embodiment of the present invention. The circuit uses two pairs of CMIS FETs: $T_5$, $T_6$ and $T_3$, $T_4$. The transistors $T_5$ and $T_3$ are p-channel FETs, and $T_6$ and $T_4$ are n-channel FETs. Each CMIS pair constitutes an inverter, and the inverters are operationally connected in series so together they work as a non-inverting type circuit. In the Figure, IN designates an input terminal connected commonly to gate electrodes of FETs $T_5$ and $T_6$. Drain electrode of $T_5$ and source electrode of $T_6$ are connected to each other, and they are connected commonly to gate electrodes of second stage inverter FETs $T_3$ and $T_4$. The drain electrode of $T_3$ and source electrode of $T_4$ are connected to each other and provide an output signal to the output terminal OUT.

Unlike the circuit of Fig. 5, the $\beta$ of the FETs $T_5$ and $T_6$ are adjusted; the other parts are not altered. Therefore, the switching time and switching capacity of $T_3$ and $T_4$ are not altered, but the switching speed of the driving buffer circuit ($T_5$ and $T_6$) is adjusted. Usually the adjustment of the current waveform at the output side of an FET is difficult, because the load varies so often, but in the embodiment of the present invention, the load of the driving buffer FETs $T_5$ and $T_6$ is always constant (the gate circuits of the output buffer circuit $T_3$ and $T_4$). Therefore, the input waveform to $T_3$ and $T_4$ is varied by varying the $\beta$ of the driving FETs $T_5$ and $T_6$. For example, if the $\beta$ of $T_5$ is made to half that of the corresponding FET ($T_1$) of the circuit of Fig. 5, that is $\beta_5 = 1/2\beta_1$, the current of the driving buffer circuit is halved, and accordingly the waveform at point B is blunted, and transient current $dI/dt$ and switching noise are reduced by approximately half.

In the above explanation the noise on the $V_{SS}$ side has been described, but similar considerations apply to noise induced on the $V_{DD}$ side. In this case, a comparison of $\beta_6$ of $T_6$ to the $\beta$ of $T_2$ will lead to the same conclusions.

As mentioned above, $\beta$ is varied by varying the ratio of gate width W to gate length L (W/L). Of course, the adjustment of the ratio W/L can be performed at a chip design stage, but since the adjustment is not critical it can be effected using a master slice technology. Details will be described below with reference to some embodiments.

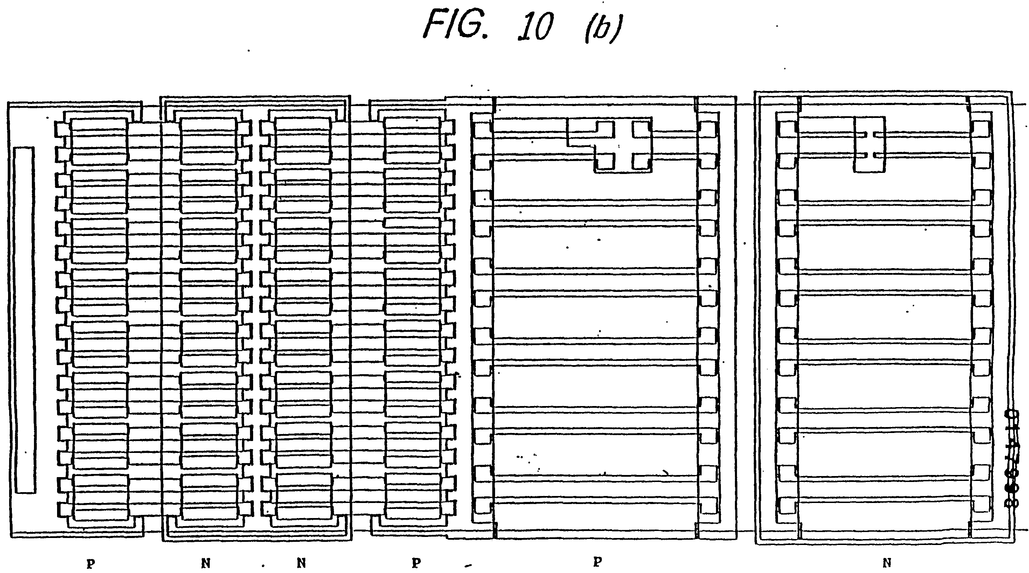

Fig. 10(a) shows schematically a plan view of a gate array LSI in accordance with an embodiment of the present invention. In the Figure, 20 designates the chip, on a central part of which the internal logic circuit (main logic circuits) 23 is fabricated. Details of the main logic circuits are omitted in the Figure. Fabricated on the peripheral part of the chip 20 are bonding pads 21, which are connected to (pins of) the package of the chip by bonding wires (not shown). I/O (input/output) circuits 22 are located between the bonding pads 21 and the internal logic circuits 23. The I/O circuits 22 handle high currents and include circuitry in accordance with the present invention. Blank areas of the chip are used for wiring between circuits, but such wiring is omitted from the Figure for the sake of simplicity.

Fig. 10(b) is a magnified plan view of an I/O circuit 22 portion of the chip of Fig. 10(a), indicating patterns of small and large-sized FETs. On the left-hand side of the Figure small-size FETs are arranged, and on the right-hand side large-size FETs are arranged. There are also included p-channel and n-channel FETs. They are arranged in rows and columns as shown in the Figure, for the sake of design and fabrication convenience. In the Figure, columns of p-channel and n-channel FETs are designated by P and N respectively.

Figs. 10 show a general pattern arrangement, and accordingly there may be many modifications and variations within the scope of the present invention. For example, intermediate-size transistors may be included to meet the needs of circuit design. In Fig. 10(b), examples of intermediate-size FETs are shown on the first row of the righthand-side columns. Control of $\beta$ or adjustment of driving current is performed by selection of the size of FET employed and by wiring them in the manner used for designing a master slice chip.

By using such a master slice technique, it is unnecessary to design the chip from the beginning of the fabrication process. The same patterned chip, prepared in advance, can be used to meet various kinds of requirement. For example, in order to drive a heavy load, a number of the large FETs may be used in parallel to construct and output buffer circuit. For constructing a driving buffer circuit, an appropriate number and size of FETs are selected in accordance with the teaching of the present invention. They can be wired for any buffer circuit merely by varying the wiring pattern.

Figs. 11 show an example of a driving gate circuit, the driving capacity ($\beta$ or maximum current) of which can be varied by varying its wiring pattern. In Fig. 11, (a) is a plan view of the gate circuit schematically showing its pattern as appearing on the chip surface, (b) and (c) show cross-sectional views, along lines AA and BB respectively, showing bulk structure of p-channel and n-channel FETs, and (d) is an equivalent circuit diagram.

In these Figures, 1 designates an n-type silicon substrate, 2 is a p-type well fabricated in the substrate. The p-channel FETs $T_{5a}$, $T_{5b}$ are fabricated as shown in the upper part of Fig. 11(a), and n-channel FETs $T_{6a}$, $T_{6b}$ are fabricated as shown in the lower part of Fig. 11(a). Reference numeral 3 designates a field oxide layer, which separates devices and on which wiring is formed. 4 is a gate oxide film, and gate electrodes 5a (first gate), 5b (second gate) are fabricated on this gate oxide film. Concerning the p-channel FETs, 6 is a $p^+$-type common drain region for the p-channel FETs, and 7a and 7b are first and second $p^+$-type source regions. Concerning the n-channel FETs, 8 is an $n^+$-type common drain region, and 9a and 9b are respectively first and second $n^+$-type source regions. As can be seen in the Figures, the gate electrodes of $T_{5a}$ and $T_{6a}$ are connected to each other by the first gate 5a, and commonly connected to the first input terminal IN1, and the gate electrodes of $T_{5b}$ and $T_{6b}$ are connected to each other by the second gate 5b, and commonly connected to the second input terminal IN2. Thus, complementary circuits, aligned in parallel with one another, are provided.

Structure and fabrication process for such chips are quite common in the art so details thereof are omitted.

The gate width of the FETs in Fig. 11 are designed to be half of that of the driving FETs $T_1$ and $T_2$ in previous Figures 1 to 5. Therefore, if the FETs of Fig. 11 are used for the driving gate, an input signal to an output FET is blunted. By varying the connection of the FETs it is possible to realize various kinds of output circuit having low switching noise.

Figs. 12 show examples of wiring of the circuit pattern of Fig. 11. The Figure shows connections for realizing a circuit having a half driving capacity (driving current). Fig. 12(a) shows schematically the wiring pattern, and Fig. 12(b) shows its equivalent circuit. In this case only a half (lefthand-side) of the pattern is used. In the Figure, heavy lines show the wiring pattern, and points C designate points where the wiring should be contacted to electrodes. Contact is made directly to the electrodes, or through contact holes made in an insulation layer covering the surface of the electrodes. Such wiring is conventional in the art.

In Figs. 12, one of the common gates (IN1) is used for input IN, and the first $n^+$-type region 7a and the first $p^+$-type region 9a are connected to each other, so the FETs $T_{5a}$ and $T_{6a}$ are connected in series between $V_{DD}$ and $V_{SS}$. The right half of the pattern is not used, so the source and drain electrodes of FETs $T_{5b}$ and $T_{6b}$ are shorted to each other. If the circuit of Figs. 12 is used for driving an output buffer circuit, the input signal for the output buffer circuit is blunted, since the gate widths of the FETs $T_{5a}$ and $T_{6a}$ are effectively decreased to half that of FETs $T_1$ and $T_2$, and noise is reduced.

Figs. 13 show another example of wiring of the circuit pattern of Figs. 11, in which the driving current is increased to twice that of Figs. 12 in order to drive a larger output circuit. Fig. 13(a) shows the wiring pattern and Fig. 13(b) shows its equivalent circuit diagram. In this example the left and right halves of the pattern are used in parallel. In the Figures, heavy lines indicate wiring lines, and points Cs indicate parts where wiring circuits should contact electrodes. It will be clear to one skilled in the art that the pattern of (a) corresponds to the circuit of (b), and its driving capacity is doubled as compared to the circuit of Figs. 12.

In the foregoing examples circuit patterns having common source or common drain FETs were used, but it is obvious that any master slice pattern can be used for the purpose of the present invention.

Figs. 14 show by symbols several output circuits illustrating how the driving capacity of input (driving) and output buffer circuits can be varied by connecting unit circuits in series or parallel, to illustrate the effect when a selection is made in accordance with the present invention.

In Figs. 14, G designates buffer circuits, and IN and OUT designate respectively input and output terminals of the circuit. A larger symbol indicates a larger buffer circuit. Fig. 14 shows cases in which one or two input buffer circuits and output buffer circuits are combined. However, it will be obvious to one skilled in the art that the numbers of the circuits to be combined may be extended or varied. Thus, it should be considered that Fig. 14 shows only typical examples.

In Figs. 14, (a) is a true-type output circuit composed of two inverters, $G_1$ being the driving buffer gate and $G_2$ the output buffer gate.

The circuit of (b) provides twice the driving capacity of the circuit of (a) and is composed of parallel circuits as in (a). $G_3$ and $G_4$ correspond respectively to $G_1$ and $G_2$. In this case the delay to the output signal is the same as that of (a), but noise is doubled.

In the circuit of (c), which uses the teaching of the present invention, the output buffer gate $G_6$ is twice that of (a), so it has the same driving capacity as the circuit of (b). However, the driving buffer circuit comprises only one circuit $G_5$, which corresponds to $G_1$ of the circuit (a). So, signal delay time is larger than the delay time of the circuits (a) or (b), but noise is reduced below the level of (a). Generally the load connected to the output OUT3 will include stray capacitance, so the effect of the present invention upon signal delay time is not so marked in comparison with the delay time of the circuit (b).

The circuit of (d) has an input buffer gate $G_7$ of double driving capacity, but the output buffer circuit $G_8$ has the same driving capacity to that of the circuit (a). This circuit has the highest switching speed, but this speed is not twice the speed of circuit (a), because the switching time is almost wholly determined by the switching speed of the output buffer circuit $G_8$. On the other hand noise is almost twice that of the circuit (a).

Table 1 summarizes measured data obtained from experiments carried out to demonstrate the above considerations. Buffer circuits corresponding to (a), (b), (c) and (d) of Fig. 14 were combined from a standard master slice pattern. The buffer circuits were tested respectively in cases in which there was no load capacitance and in cases in which they were loaded by capacitors of values 10 pF, 100 pF and 200 pF respectively. For each case, delay time and noise voltage were measured. In the Table, the delay time is subdivided into the delay time due to the load capacitance and total delay time. The former is obtained by subtracting the no-load capacitance delay time from the total delay time. The noise voltage is given in relative values.

The measured values in the Table confirm the following considerations which relate to the present invention. For example:

total delay time increases as the load capacitance increases, and it is mainly determined by the capacitance;

the no-load delay time is equal for the circuits (a) and (b), and the delay time for the circuit (d) is shortest and for the circuit (c) is longest;

but the shortest and longest delay times cannot be half or twice the delay time of (a) or (b) respectively;

to increase the driving capacity of the output buffer circuit has the effect of reducing the delay time, but this effect is discounted or mitigated by the influence of load capacitance;

on the other hand, the noise increases almost proportionally to the driving capacity of the output circuit (compare (a) and (b));

but the noise is reduced very much by reducing the driving capacity of the driving buffer circuit (compare (a), (b) and (c)); and

increasing the driving capacity of the driving buffer circuit has little effect on (provides little reduction of) delay time but it increases noise very much.

## TABLE 1

| CIRCUIT TYPE | WITHOUT CAPACITANCE | LOAD CAPACITANCE | | | | | | NOISE AMPLITUDE |
|---|---|---|---|---|---|---|---|---|
| | | 10 pF | | 100 pF | | 200 pF | | |
| | | DUE TO CAPACITANCE | TOTAL DELAY | DUE TO CAPACITANCE | TOTAL DELAY | DUE TO CAPACITANCE | TOTAL DELAY | |
| | nS | nS | nS | nS | nS | nS | nS | V |
| a | 9.5 | 1.0 | 10.5 | 10.0 | 19.5 | 20.0 | 29.5 | 1a |
| b | 9.5 | 0.5 | 10.0 | 5.0 | 15.0 | 10.0 | 19.5 | 2a |
| c | 11.5 | 0.5 | 12.0 | 5.0 | 16.5 | 10.0 | 21.5 | <1a |
| d | 7.5 | 1.0 | 8.5 | 10.0 | 17.5 | 20.0 | 27.5 | ~2a |

As can be seen from these experiments, it is meaningless simply to increase the switching speed of the driving buffer circuit, and moreover such an increase has a serious adverse effect on noise. Of course, it is important to increase the switching speed of main logic circuit and output buffer circuit in order to attain high speed for the device, but so far as the driving buffer circuit is concerned its switching speed or driving capacity should be controlled wisely from the standpoint of switching noise.

Practically, there must be an optimum switching speed for the driving buffer circuit, which is determined by the load conditions of the output buffer circuit. Generally speaking, the switching speed of the driving buffer circuit is preferably from two to five times as high as that of the output buffer circuit. If the ratio of the switching speed of the input to output buffer circuit becomes larger the noise increases and, on the other hand, if the ratio becomes smaller the circuit overall loses switching speed.

As has been described above, previous output buffer circuits are intended to increase switching speed, and consideration is not given to noise. Therefore, the switching speed of the driving circuit has been increased, but this has not improved the overall switching speed so much, whilst it has increased the problem of the switching noise. The present invention, on the contrary, tends to decrease the speed of the driving circuit intentionally, without increasing overall signal delay time unduly, but significantly decreasing noise. This is a design concept exactly contrary to previously accepted teaching in the prior art, but which is effective for LSI circuit design. The switching speed can be adjusted by master slice technology.

The present invention is particularly valuable in application to integrated circuits (LSIs or VLSIs) with more than 2000 gates per package. In other words, it is particularly value for ICs having more than forty pins per package.

The invention is valuable for ICs for which the main logic circuitry operates on the basis of a current of the order of one microamp per FET, or less (when operated for example at a clock frequency of 10 MHz). In such an IC output current is typically from 3 to 10 mA DC per output buffer gate, about 40 mA peak for a pulse (e.g. 20 nS) per output buffer gate).

In embodiments of the present invention switching speed of an output buffer circuit (connected to a load) is approximately in the range from a few nanoseconds (e.g. 7 or 8 nanoseconds) to 50 nanoseconds. The switching speed of the driving buffer circuit is in the range from 1.5 to 10 nanoseconds, depending on output buffer circuit switching speed. The switching speed of the driving buffer circuit is preferentially from two to five times faster than the switching speed of the output buffer circuit.

## Claims

1. A semiconductor integrated circuit device, having a plurality of output circuits (22) each comprising:
   (i) an output buffer circuit ($G_2$, $G_6$) having a relatively large current handling capacity and operable to provide an output signal (OUT, OUT1, OUT3) to an external load (CL), and
   (ii) a driving buffer circuit ($G_1$, $G_5$) having a relatively small current handling capacity and operable to provide signals to drive the output buffer circuit,
   characterised in that the switching speed of the driving buffer circuit, for driving the output circuit buffer, is in the range over which the switching performance of the output circuit buffer is substantially determined by the switching speed of the driving buffer circuit, and in that the switching speed of the driving buffer circuit is sufficiently low that switching noise, generated on a power supply line of the device upon switching of the output buffer circuit, is restricted, without reduction of the current handling capacity of the output buffer circuit.

2. A device as claimed in claim 1, wherein each output circuit (22) comprises a plurality of standard gate circuits, having predetermined standard patterns, provided in the device, the driving buffer circuit and the output buffer circuit being formed by combining such standard gate circuits, the appropriate numbers and/or sizes of standard gates being selected for each buffer circuit.

3. A device as claimed in claim 2, wherein the standard gate circuits include such circuits based on transistors of different sizes, output buffer circuits and driving buffer circuits comprising respectively transistors of different sizes.

4. A device as claimed in claim 1, 2 or 3, wherein each driving buffer circuit includes fewer transistors than its associated output buffer circuit.

5. A device as claimed in any preceding claim, wherein transistors in each driving buffer circuit are of smaller current handling capacity than transistors in the associated output buffer circuit.

6. A device as claimed in any preceding claim, wherein each output circuit comprises complementary MIS FETs.

7. A device as claimed in any preceding claim, wherein the device is silicon-based.

8. A device as claimed in any preceding claim, wherein, in each output circuit, the current handling capacity of the driving buffer circuit is so restricted that the rate of change of the signals provided to drive the output buffer circuit is restricted, whereby the rate of change of the relatively large current handled by the output buffer circuit, upon switching of the output buffer circuit is restricted, so that switching noise is restricted.

9. A device as claimed in any preceding claim, wherein, in each output circuit, the current handling capacity of the driving buffer circuit is restricted by restricting the effective current amplification factor ($\beta_5$,

$\beta_6$) of transistors in that buffer circuit.

10. A device as claimed in any preceding claim, wherein, in each output circuit, the or each transistor in the output buffer circuit for delivering the relatively large current is normally operated in saturation when delivering that current.

11. A device as claimed in any preceding claim, wherein, in each output circuit, the switching speed of the driving buffer circuit is no more than five times faster than the switching speed of the output buffer circuit.

12. A device as claimed in claim 11, wherein, in each output circuit, the switching speed of the driving buffer circuit is at least twice as fast as the switching speed of the output buffer circuit.

13. A device as claimed in any preceding claim, wherein, in each output circuit, the switching speed of the output buffer circuit is in the range from a few nanoseconds (e.g. 7 or 8 nanoseconds) to 50 nanoseconds, and the switching speed of the driving buffer circuit is from two to five times faster than the switching speed of the output buffer circuit.

14. A device as claimed in any of claims 1 to 12, wherein, in each output circuit, the switching speed of the driving buffer circuit is in the range 1.5 nanoseconds to 10 nanoseconds and is from two to five times faster than the switching speed of the output buffer circuit.

15. A device as claimed in any preceding claim, being an LSI or a VLSI having at least two thousand gates and/or more than forty pins on its package.

16. An LSI or VLSI as claimed in claim 15, having main logic circuitry with an operating current of the order of one microamp per FET, or less, and wherein the output current delivered by each output circuit is of the order of 3 to 10 milliamps DC per output buffer gate and/or of the order of 40 milliamps peak per output buffer gate.

**Patentansprüche**

1. Integrierte Halbleiterschaltungsvorrichtung mit einer Vielzahl von Ausgangsschaltungen (22), die jeweils umfassen:

:(i) eine Ausgangspufferschaltung ($G_2$, $G_6$), die eine relativ große Stromverarbeitungskapazität hat und betriebbar ist, um ein Ausgangssignal (OUT, OUT1, OUT3) an eine externe Last (CL) zu liefern, und

(ii) eine triebende Pufferschaltung ($G_1$, $G_5$), die eine relativ kleine Stromverarbeitungskapazität hat und betriebbar ist, um Signale zu liefern, um die Ausgangspufferschaltung zu trieben,
dadurch gekennzeichnet, daß die Schaltgeschwindigkeit der treibenden Pufferschaltung, zum Treiben des Ausgangsschaltungspuffers, in dem Bereich ist, über welchem die Schaltleistung des Ausgangsschaltungspuffers im wesentlichen durch die Schaltgeschwindigkeit der treibenden Pufferschaltung bestimmt ist, und daß die Schaltgeschwindigkeit der treibenden Pufferschaltung hinreichend niedrig ist, so daß Schaltrauschen, welches auf einer Energieversorgungsleitung der Vorrichtung beim Schalten der Ausgangspufferschaltung erzeugt wird, beschränkt ist, ohne Reduktion der Stromverarbeitungskapazität der Ausgangspufferschaltung.

2. Vorrichtung nach Anspruch 1, bei der jede Ausgangschaltung (22) eine Vielzahl von Standardgateschaltungen umfaßt, die vorbestimmte Standardmuster haben, die in der Vorrichtung vorgesehen sind, die treibende Pufferschaltung und die Ausgangspufferschaltung durch Kombinieren solcher Standardgateschaltungen gebildet sind, wobei die geeigneten Zahlen und/oder Größen der Standardgates für jede Pufferschaltung ausgewählt werden.

3. Vorrichtung nach Anspruch 2, bei der die Standardgateschaltungen solche Schaltungen, die auf Transistoren von verschiedenen Größen basieren, Ausgangspufferschaltungen und Treiberpufferschaltungen enthalten, die jeweils Transistoren von verschiedenen Größen umfassen.

4. Vorrichtung nach Anspruch 1, 2 oder 3, bei der jede treibende Pufferschaltung weniger Transistoren als ihre zugeordnete Ausgangspufferschaltung umfaßt.

5. Vorrichtung nach einem der vorhergehenden Ansprüche, bei der Transistoren in jeder treibenden Pufferschaltung eine kleinere Stromverarbeitungskapazität als die Transistoren in der zugeordneten Ausgangspufferschaltung haben.

6. Vorrichtung nach einem der vorhergehenden Ansprüche, bei der jede Ausgangsschaltung komplementäre MIS-FETs umfaßt.

7. Vorrichtung nach einem der vorhergehenden Ansprüche, bei der die Vorrichtung auf Silicium basiert.

8. Vorrichtung nach einem der vorhergehenden Ansprüche, bei der in jeder Ausgangspufferschaltung die Stromverarbeitungskapazität der treibenden Pufferschaltung so beschränkt ist, daß die Rate der Änderung der Signale, die zum Treiben der Ausgangspufferschaltung geliefert werden, beschränkt ist, wodurch die Rate eine Änderung des relativ großen Stromes, der von der Ausgangspufferschaltung verarbeitet wird, beim Schalten der Ausgangspufferschaltung beschränkt ist, so daß ein Schaltrauschen beschränkt ist.

9. Vorrichtung nach einem der vorhergehenden Ansprüche, bei der, in jeder Ausgangsschaltung, die Stromverarbeitungskapazität der treibenden Pufferschaltung durch Beschränken des effektiven Strom-verstärkungsfaktors ($\beta_5$, $\beta_6$) der Transistoren in der genannten Pufferschaltung beschränkt ist.

10. Vorrichtung nach einem der vorhergehenden Ansprüche, bei der, in jeder Ausgangschaltung, der oder jeder Transistor in der Ausgangspufferschaltung zum Liefern eines relative großen Stromes normalerweise in der Sättigung betrieben wird, wenn der jenen Strom liefert.

11. Vorrichtung nach einem der vorhergehenden Ansprüche, bei der, in jeder Ausgangsschaltung, die Schaltgeschwindigkeit der treibenden Pufferschaltung nicht mehr als fünf Mal schneller als die Schaltgeschwindigkeit der Ausgangspufferschaltung ist.

12. Vorrichtung nach Anspruch 11, bei der, in jeder Ausgangsschaltung, die Schaltgeschwindigkeit der treibenden Pufferschaltung wenigstens zwei Mal so schnell wie die Schaltgeschwindigkeit der Ausgangspufferschaltung ist.

13. Vorrichtung nach einem der vorhergehenden Ansprüche, bei der, in jeder Ausgangschaltung, die Schaltgeschwindigkeit der Ausgangspufferschaltung im Bereich von einigen wenigen Nanosekunden (z.B. 7 oder 8 Nanosekunden) bis 50 Nanosekunden liegt, und die Schaltgeschwindigkeit der treibenden Pufferschaltung von zwei bis fünf Mal schneller als die Scha    aschwindigkeit der Ausgangspufferschaltung ist.

14. Vorrichtung nach einem der Ansprüche 1 bis 12, bei der, in jeder Ausgangsschaltung, die Schaltgeschwindigkeit der treibenden Pufferschaltung im Bereich von 1,5 Nanosekunden bis 10 Nanosekunden liegt, und von zwei bis fünf Mal schneller als die Schaltgeschwindigkeit der Ausgangspufferschaltung ist.

15. Vorrichtung nach einem der vorhergehenden Ansprüche, welche eine LSI oder eine VLSI ist, die wenigstens 2000 Gates und/oder mehr als 40 Stifte an ihrer Packung hat.

16. LSI oder VLSI nach Anspruch 15, mit einer Hauptlogikschaltung mit einem Betriebsstrom von der Größenordnung von 1 Mikroampère pro FET, oder weniger, und bei der der Ausgangsstrom, der von jeder Ausgangschaltung geliefert wird, in der Größenordnung von drei bis zehn Milliampère Gleichstrom pro Ausgangspuffergate und/oder von der Größenordnung von 40 Milliampère Spitze pro Ausgangspuffergate ist.

## Revendications

1. Dispositif à circuit intégré semiconducteur, possédant plusieurs circuits de sortie (22) qui comprennent chacun:

(i) un circuit tampon de sortie ($G_2$, $G_6$) possédant une capacité de manipulation de courant relativement importante et ayant pour fonction de fournir un signal de sortie (OUT, OUT1, OUT3) à une charge externe (CL), et

(ii) un circuit tampon d'excitation ($G_1$, $G_5$) possédant une capacité de manipulation de courant relativement petite et ayant pour fonction de fournir des signaux afin d'exciter le circuit tampon de sortie, caractérisé en ce que la vitesse de commutation du circuit tampon d'excitation, servant à exciter le tampon du circuit de sortie, se trouve dans l'intervalle sur lequel les performances de commutation du tampon du circuit de sortie sont sensiblement déterminées par la vitesse de commutation du circuit tampon d'excitation, et en ce que la vitesse de commutation du circuit tampon d'excitation est suffisamment faible pour que le bruit de commutation, créé sur une ligne d'alimentation électrique du dispositif au moment de la commutation du circuit tampon de sortie, soit limité, sans réduction de la capacité de manipulation de courant du circuit tampon de sortie.

2. Dispositif selon la revendication 1, où chaque circuit de sortie (22) comprend plusieurs circuits de portes normalisées, ayant des configurations normalisées prédéterminées, prévus dans le dispositif, le circuit tampon d'excitation et le circuit tampon de sortie étant formés par combinaison de ces circuits de portes normalisées, les nombres et, ou bien, les tailles appropriés des portes normalisées étant sélectionnés pour chaque circuit tampon.

3. Dispositif selon la revendication 2, où les circuits de portes normalisées comportent des circuits reposant sur des transistors de tailles différentes, les circuits tampons de sortie et les circuits tampons d'excitation comprenant respectivement des transistors de tailles différentes.

4. Dispositif selon la revendication 1, 2 ou 3, où chaque circuit tampon d'excitation comporte moins de transistors que son circuit tampon de sortie associé.

5. Dispositif selon l'une quelconque des revendications précédentes, où les transistors de chaque circuit tampon d'excitation ont une plus petite capacité de manipulation de courant que les transistors du circuit tampon de sortie associé.

6. Dispositif selon l'une quelconque des revendications précédentes, où chaque circuit de sortie comprend des transistors à effet de champ MIS complémentaires.

7. Dispositif selon l'une quelconque des revendications précédentes, où le dispositif est à base de silicium.

8. Dispositif selon l'une quelconque des revendications précédentes, où, dans chaque circuit de sortie, la capacité de manipulation de courant du circuit tampon d'excitation est limitée de façon que le taux de variation des signaux prévus pour exciter le circuit tampon de sortie soit limité, de sorte que le taux de variation du courant relativement important manipulé par le circuit tampon de sortie, au moment de la commutation du circuit tampon de sortie, est limité, si bien que le bruit de commutation est limité.

9. Dispositif selon l'une quelconque des revendications précédentes, où, dans chaque circuit de sortie, la capacité de manipulation de courant du circuit tampon d'excitation est limitée du fait de la limitation du facteur d'amplification de courant effectif ($\beta_5$, $\beta_6$) des transistors de ce circuit tampon.

13

10. Dispositif selon l'une quelconque des revendications précédentes, où, dans chaque circuit de sortie, le transistor ou chaque transistor du circuit tampon de sortie servant à délivrer le courant relativement important fonctionne normalement en saturation lorsqu'il délivre ce courant.

11. Dispositif selon l'une quelconque des revendications précédentes, où, dans chaque circuit de sortie, la vitesse de commutation du circuit tampon d'excitation n'est pas supérieure à cinq fois la vitesse de commutation du circuit tampon de sortie.

12. Dispositif selon la revendication 11, où, dans chaque circuit de sortie, la vitesse de commutation du circuit tampon d'excitation est au moins deux fois plus grande que la vitesse de commutation du circuit tampon de sortie.

13. Dispositif selon l'une quelconque des revendications précédentes, où, dans chaque circuit de sortie, la vitesse de commutation du circuit tampon de sortie est comprise dans l'intervalle allant de quelques nanosecondes (par exemple 7 ou 8 ns) à 50 ns, et la vitesse de commutation du circuit tampon d'excitation est de deux à cinq fois plus grande que la vitesse de commutation du circuit tampon de sortie.

14. Dispositif selon l'une quelconque des revendications 1 à 12, où, dans chaque circuit de sortie, la vitesse de commutation du circuit tampon d'excitation est comprise dans l'intervalle de 1,5 ns à 10 ns est est de deux à cinq fois plus grande que la vitesse de commutation du circuit tampon de sortie.

15. Dispositif selon l'une quelconque des revendications précédentes, qui est un circuit intégré à grande échelle (LSI) ou un circuit intégré à très grande échelle (VLSI) possédant au moins deux mille portes et, ou bien, plus de quarante broches sur son boîtier.

16. Circuit intégré à grande échelle ou circuit intégré à très grande échelle selon la revendication 15, possédant un circuit logique principal dont le courant de fonctionnement est de l'ordre de 1 µA par transistor à effet de champ, ou moins, et où le courant de sortie délivré par chaque circuit de sortie est de l'ordre de 3 à 10 mA de courant continu par porte de tampon de sortie et, ou bien, de l'ordre de 40 mA crête à crête par porte de tampon de sortie.

# FIG. 1

(a)

(b)

# FIG. 2

(a)

(b)

# FIG. 3

(a)

(b)

1

# FIG. 4

(a)

(b)

(c)

# FIG. 5

# FIG. 6

## FIG. 7

## FIG. 9

# FIG. 8

(a)

(b)

(c)

# FIG. 10

(a)

FIG. 10 (b)

# FIG. 11

(a)

(b)

(c)

(d)

# FIG. 12

# FIG. 13

(a)

(b)

# FIG. 14

(a)

IN1    $G_1$    $G_2$    OUT1

(b)

$G_3$    $G_4$

IN2    OUT2

(c)

$G_5$    $G_6$

IN3    OUT3

(d)

$G_7$    $G_8$

IN4    OUT4